(19) Europäisches Patentamt
European Patent Office
Office européen des brevets

(11) EP 2 738 561 B1

(12) **EUROPEAN PATENT SPECIFICATION**

(45) Date of publication and mention
of the grant of the patent:
**12.01.2022 Bulletin 2022/02**

(51) Int Cl.:
***G01R 31/08*** *(2020.01)*          ***H02H 3/34*** *(2006.01)*

(21) Application number: **13193186.7**

(22) Date of filing: **15.11.2013**

(54) **Method and device for determining location of earth fault**

Verfahren und Vorrichtung zur Bestimmung des Ortes eines Erdschlusses

Procédé et dispositif de détermination de localisation de défaut à la terre

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.11.2012 CN 201210505394**

(43) Date of publication of application:
**04.06.2014 Bulletin 2014/23**

(73) Proprietor: **Schneider Electric Industries SAS
92500 Rueil-Malmaison (FR)**

(72) Inventor: **Li, Rong
201114 Shanghai (CN)**

(74) Representative: **Manitz Finsterwald
Patent- und Rechtsanwaltspartnerschaft mbB
Martin-Greif-Strasse 1
80336 München (DE)**

(56) References cited:
EP-A2- 1 089 081          US-A1- 2006 097 728
US-A1- 2006 142 964          US-A1- 2012 068 717

• NOVOSEL D ET AL: "OPTIMAL FAULT LOCATION FOR TRANSMISSION SYSTEMS", ABB REVIEW, ABB ASEA BROWN BOVERI, ZURICH, CH, no. 8, 1 January 1994 (1994-01-01), pages 20-27, XP000471024, ISSN: 1013-3119
• FECTEAU C: "Accurate fault location algorithm for series compensated lines using two-terminal unsynchronized measurements and hydro-quebec's field experience", ANNUAL WESTERN PROTECTIVE RELAY CONFER,, vol. 33, 1 January 2006 (2006-01-01), pages 1-16, XP007906022,
• POPOVIC L M: "A digital fault-location algorithm taking into account the imaginary part of the grounding impedance at the fault place", IEEE TRANSACTIONS ON POWER DELIVERY, IEEE SERVICE CENTER, NEW YORK, NY, US, vol. 18, no. 4, 1 October 2003 (2003-10-01), pages 1489-1496, XP011103371, ISSN: 0885-8977, DOI: 10.1109/TPWRD.2003.817800

**Description**

FIELD OF INVENTION

The present invention relates to a localization of an earth fault in a grid.

BACKGROUND

A localization of an earth fault is always a challenging task. There are many factors which deteriorate an accuracy of an estimated fault location, such as a fault resistance and a load. Distribution networks are especially challenging as they have specific features which further complicate the task for a fault localization algorithm. These specific features include non-homogeneity of line, load taps, etc., for example.

In modern microprocessor-based protection relays, impedance-based fault localization algorithms have become industry standard. The reason for their popularity is that they can be easily implemented, as they utilize the same signals as the other functions.

However, existing fault localization algorithms neglect a distributed shunt capacitance of a feeder. The performances of these algorithms are very promising for an overhead network or a mixed overhead/underground network when a percentage of underground cables is low (for example, less than 30% of a total length of the feeder downstream from an Intelligent Electrical Device IED). However, when the percentage of the underground cables increases, the distributed shunt capacitance will also increase, therefore the calculation accuracy of the existing fault localization algorithms will be heavily deteriorated when the percentage of the underground cable is high.

US20060142964 A1 relates to a method to locate a fault in a section of a transmission line using measurements of current, voltage and angles between the phases at a first (A) and a second (B) end of said section. The method is characterised by the teps of, after the occurrence of a fault along the section, calculating a distance (d.sub.A, d.sub.B) to a fault dependent on a fault current measured at one of said first and second ends and phase voltages measured at both of said first and second ends (A, B), where the distance to fault is calculated from the end (A or B) where the fault current is measured. The method is particularly suitable when a current transformer at either of the first or second ends (A, B) is saturated. If so, then, a distance (d) to a fault is calculated dependent on a fault current measured at the non-affected end and phase voltages measured at both the affected end and the non-affected end.

SUMMARY

Embodiments of the present disclosure provide a method and device for determining a location of an earth fault, which are capable of ensuring an accuracy of the localization result no manner what a percentage of the underground cables is.

According to one aspect of the present disclosure, there is provided a method for determining a location of an earth fault according to claim 1, comprising: calculating a zero sequence component and a positive sequence component in a grid based on a distributed shunt capacitance; and determining a distance to a measuring point from an earth fault point by using a negative sequence component, the calculated zero sequence component and the calculated positive sequence component.

According to another aspect of the present disclosure, there is provided a device for determining a location of an earth fault according to claim 8, comprising: a calculating means for calculating a zero sequence component and a positive sequence component in a grid based on a distributed shunt capacitance; and a determining means for determining a distance to a measuring point from an earth fault point by using a negative sequence component, the calculated zero sequence component and the calculated positive sequence component.

Therefore, according to the embodiments of the present disclosure, the zero sequence component and the positive sequence component are calculated by taking the distributed shunt capacitance into consideration, so that the accuracy of the determined fault location may be ensured even in a case that the percentage of the underground cable is high.

BRIEF DESCRIPTION OF THE DRAWINGS

The disclosure will be easily understood with the aid of the following detail description with reference to the accompanying drawings, in which a same reference sign refers to units or elements with a same structure and in which:

Fig. 1 is a flow chart schematically showing a method for determining a location of an earth fault according to an embodiment of the present disclosure;
Fig.2 schematically shows an equivalent diagram of symmetric components for a single phase to earth fault;

Figs. 3 shows a schematic equivalent circuit of a feeder;

Fig. 4 shows a schematic equivalent circuit of a two-terminal network representing a positive sequence network downstream from IED, wherein a feeder impedance is neglected;

Fig. 5 shows a schematic simplified diagram for estimating a total length *l* of the downstream feeder;

Fig. 6 shows a schematic block diagram of a device for determining a location of an earth fault according to the embodiment of the present disclosure.

DETAILED DESCRIPTION

Following descriptions are given hereinafter with reference to the accompanying drawings to assist those skilled in the art to fully understand the exemplary embodiments of the present disclosure as defined by the claims. The following descriptions may include various details to assist in understanding, and these details should be construed as illustrative. Therefore, those skilled in the art should understand that various modifications and variations in forms and details can be made in the exemplary embodiments without departing from the scope of the invention. Likewise, for the sake of conciseness and clarity, descriptions for well-known functions and structures are omitted.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed as a second element, component, region, layer or section without departing from the teachings of the present invention.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Applications of the Embodiments of the present disclosure are not limited to any particular system, but can be used with any three-phase system so as to determine a location of the phase-to-earth fault on three-phase feeders in a grid. For example, the feeders may be overhead lines, underground cables, or mixture of overhead lines and underground cables.

Hereinafter, embodiments of the present disclosure are described by taking the distribution network as an example, but those skilled in the art should understand that the power system to which the embodiments of the present disclosure may be applied may be a transmission grid, a distribution network or elements in the transmission grid or distribution network, and may include one or more feeders. Furthermore, the embodiments of the present disclosure are not limited to be used in systems adopting 50Hz or 60Hz baseband, and are not limited to any particular voltage level.

The embodiments of the present disclosure will described below in details with reference to the accompanying drawings.

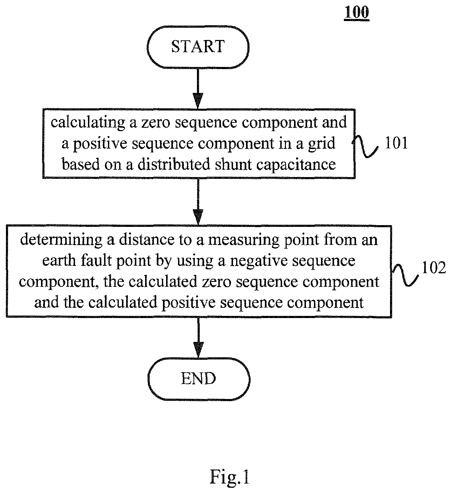

Fig.1 is a flow chart schematically showing a method 100 for determining a location of an earth fault according to an embodiment of the present disclosure.

As shown in Fig.1, in step 101 of the method 100, a zero sequence component and a positive sequence component in a grid are calculated based on a distributed shunt capacitance. In step 102 of the method 100, distance to a measuring point from an earth fault point is determined by using a negative sequence component, the calculated zero sequence component and the calculated positive sequence component.

Therefore, according to the embodiment of the present disclosure, the zero sequence component and the positive sequence component in the grid are calculated by taking the distributed shunt capacitance into consideration, so that an accuracy of the determined fault location can be ensured even in a case that the percentage of the underground cable is high.

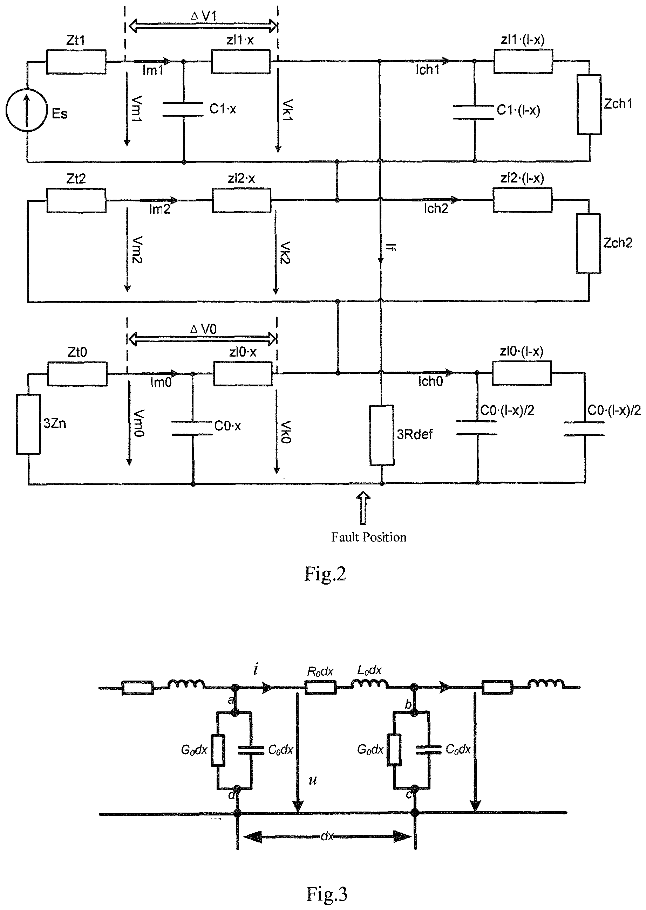

Fig.2 schematically shows an equivalent diagram of symmetric components for a single phase to earth fault, wherein a fault point locates a position with a distance x to a measurement point at which an Intelligent Electrical Device IED is disposed. The method 110 for determining the location of the earth fault according to the embodiment of the present disclosure as shown in Fig.1 may be performed by the IED, and the IED may be implemented in various devices, such as a protection relay, a fault passage indicators (FPI), a remote terminal units (RTU), etc., but the embodiment of the present disclosure is not limited thereto. Hereinafter, terms of "at the measurement point" and "at the IED" can be exchanged.

Symbols shown in Fig.2 are illustrated in the following table 1.

Table 1

| Symbol | Meaning |
|---|---|
| $Es$ | =phase voltage at the IED location (i.e., at the measurement point) before the fault |
| $Zt1$, $Zt2$, $Zt0$ | =positive, negative and zero sequence transformer impedance |
| $Zn$ | transformer neutral grounding impedance (infinity for ungrounded) |
| $zl1$ $zl2$, $zl0$ | =positive, negative and zero sequence feeder impedance per unit length |
|  | (mixture of overhead line and underground cable) (input by user separately) |
| $l$ | =total length of downstream feeder |
| $x$ | =distance to the IED (measurement point) from the fault point |
| $Zch1$, $Zch2$ | =positive and negative equivalent load impedance |
| $Rdef$ | =phase to ground fault impedance |
| $Im1$, $Im2$, $Im0$ | =positive, negative and zero sequence current calculated from the phase current measured at the IED location |
| $Vm1$, $Vm2$, $Vm0$ | =positive, negative and zero sequence voltage calculated from the phase voltage measured at the IED location |
| $Vk1$, $Vk2$, $Vk0$ | =positive, negative and zero sequence voltage at the fault location |
| $If$ | =earth fault current divided by 3 |
| $Ich1$, $Ich2$ | =positive and negative sequence load current during fault |
| $C1$, $C0$ | =positive and zero sequence distributed shunt capacitance per unit length, wherein the zero sequence distributed shunt capacitance is input by user |

As for a single phase to earth fault, following equations (1) and (2) may be obtained.

$$Es = (Zt1 + zl1 \cdot x) \cdot Im1 + (Zt2 + zl2 \cdot x) \cdot Im2 + If \cdot 3Rdef + Zt0 \cdot Im0 + zl0 \cdot x \cdot Im0$$

$$\ldots(1)$$

$$Vm = Vm1 + Vm2 + Vm0 \qquad \ldots(2)$$

Wherein $Vm$ represents a phase voltage measured at the measurement point (i.e., the IED location), and in particularly is a phase voltage of a fault phase.

For $If$, it may be calculated from a negative sequence network, as shown in a equation (3) below, since $If$ is affected least in the negative sequence network.

$$If = Im2 - Ich2$$
$$Ich2 = Vm2 / Zch \qquad \ldots(3)$$
$$Zch = Vm_{prefault} / Im_{prefault}$$

Wherein $Vm_{prefault}$ represents a voltage measured at the IED location before the earth fault occurs, and $Im_{prefault}$ represents a current measured at the IED location before the earth fault occurs.

According to a theory of compound sequence network, a following equation (4) can be obtained.

$$Vm1 = Es - Im1 \cdot Zt1$$
$$Vm2 = -Zt2 \cdot Im2 \qquad \qquad \ldots(4)$$
$$Vm0 = -Zt0 \cdot Im0$$

A following equation (5) can be obtained by substituting the equation (4) into the equation (2).

$$Vm = Es - Im1 \cdot Zt1 - Zt2 \cdot Im2 - Zt0 \cdot Im0 \qquad \qquad \ldots(5)$$

A following equation (6) can be obtained by substituting the equation (1) into the equation (5) and replacing *Im0* with *If*.

$$Vm = zl1 \cdot x \cdot Im1 + zl2 \cdot x \cdot Im2 + If \cdot 3 \cdot Rdef + zl0 \cdot x \cdot If \qquad \qquad \ldots(6)$$

Generally, based on a fact that the fault impedance *Rdef* only has a real part, the distance x may be calculated, that is, the distance x is calculated according to a following equation (7).

$$imag\left(\frac{Vm - zl1 \cdot x \cdot Im1 - zl2 \cdot x \cdot Im2}{If}\right) = imag(zl0 \cdot x) \qquad \qquad \ldots(7)$$

As described above, the above equation (7) is obtained assuming that the influence on the grid caused by the distributed shunt capacitance of the feeder can be neglected. However, when the percentage of the underground cable in the grid is high, for example, the percentage of the underground cable is higher than 30% of the total length of the downstream feeder to IED, the distributed shunt capacitance of the underground cable may be up to 35 times than the distributed shunt capacitance of the overhead network, such that an error brought by the equation (7) would exceed 5%. Such result is extremely undesirable and would bring some unnecessary troubles to subsequent process of a fault removal and the like. Additionally, the accuracy of the algorithm in the equation (7) would further heavily be degraded and may bring a greater error for a further higher underground cable percentage.

Particularly, as shown in Fig.2, the distributed shunt capacitances in the positive sequence network and the zero sequence network should be considered, since both an impedance of a power source (Es) in the positive sequence network and the transformer neutral grounding impedance Zn in the zero sequence network are high when the percentage of the underground cable in the electric network is high. Only a positive sequence distributed shunt capacitance and a zero sequence distributed shunt capacitance are taken into consideration in following detailed descriptions since the distributed shunt capacitance in the negative sequence network has a little influence. However, those skilled in the art should understand that the fault location may also be determined by taking all of the positive sequence distributed shunt capacitance, the negative sequence distributed shunt capacitance, and the zero sequence distributed shunt capacitance into consideration simultaneously, which will further improve the accuracy of the localization of the earth fault.

According to the embodiment of the present disclosure, the positive sequence component and the zero sequence component in the equation (6) are replaced with a positive sequence voltage drop and a zero sequence voltage drop, respectively, and thus an equation (8) may be obtained.

$$Vm = \underline{\Delta V1} + zl2 \cdot x \cdot Im2 + If \cdot 3 \cdot Rdef + \underline{\Delta V0} \qquad \qquad \ldots(8)$$

Wherein $\Delta V1$ represents the positive sequence voltage drop and $\Delta V0$ represents the zero sequence voltage drop.

In order to obtain the $\Delta V1$ and $\Delta V0$ by using the positive sequence distributed shunt capacitance and the zero sequence distributed shunt capacitance, the feeder may be represented as a serial connection of elements with infinite small length of *dx*.

Fig.3 shows a schematic equivalent circuit for the feeder, wherein the feeder is represented as a serial connection of elements with infinite small length of *dx*, each element has an impedance $R_0 dx$ and a reactance $L_0 dx$, and there are a leak conductance $G_0 dx$ and a capacitance $C_0 dx$ between lines.

As shown in Fig.3, if a voltage and a current at the left side of *dx* are *u* and *i*, respectively, a voltage and a current at the right side of $dx$ would be $u + \dfrac{\partial u}{\partial x} dx$ and $i + \dfrac{\partial i}{\partial x} dx$ , respectively.

Applying a Kirchhoff's Current Law (KCL) to a node b, a following equation (9) may be obtained.

$$i - \left( i + \frac{\partial i}{\partial x} dx \right) = G_0 \left( u + \frac{\partial u}{\partial x} dx \right) dx + C_0 \frac{\partial}{\partial x} \left( u + \frac{\partial u}{\partial x} dx \right) dx \qquad (9)$$

Applying a Kirchhoff's Voltage Law (KVL) to a loop "a-b-c-d-a", a following equation (10) will be obtained.

$$u - \left( u + \frac{\partial u}{\partial x} dx \right) = R_0 i dx + L_0 \frac{\partial i}{\partial t} dx \qquad \ldots (10)$$

The above equation (10) may be re-written as a following equation (11) with omitting a second order of infinitesimal component and eliminating $dx$.

$$-\frac{\partial u}{\partial x} = R_0 i + L_0 \frac{\partial i}{\partial t}$$
$$-\frac{\partial i}{\partial x} = G_0 u + C_0 \frac{\partial u}{\partial t} \qquad \ldots (11)$$

After using a phasor method, the above equation (11) may be further re-written as a following equation (12).

$$-\frac{dU}{dx} = (R_0 + j\omega L_0)I = Z_0 I$$
$$-\frac{dI}{\partial x} = (G_0 + j\omega C_0)U = Y_0 U \qquad (12)$$

Wherein $Z_0$ is an impedance per unit length and may be represented as a following equation (13), and $Y_0$ is an admittance per unit length and may be represented as a following equation (14).

$$Z_0 = (R_0 + j\omega L_0) \qquad \ldots (13)$$

$$Y_0 = (G_0 + j\omega C_0) \qquad \ldots (14)$$

After solving a differential equation (12), the voltage and current at the fault point with a distance x from the measurement point may be obtained, as shown in a following equation (15).

$$U = A_1 e^{-\gamma x} + A_2 e^{\gamma x}$$
$$I = \left( A_1 e^{-\gamma x} - A_2 e^{\gamma x} \right) / Z_C$$
$$A_1 = \frac{1}{2}(U_1 + Z_C \cdot I_1) \qquad \ldots (15)$$
$$A_2 = \frac{1}{2}(U_1 - Z_C \cdot I_1)$$

Wherein $U_1$ represents the voltage at the IED, $I_1$ represents the current at the IED, $U$ represents the voltage at a location with a distance $x$ from the measurement point, $I$ represents the current at the location with the distance x from the measurement point, $\gamma$ is a propagation constant and $\gamma = \sqrt{Z_0 Y_0}$ , $Z_C$ is a characteristic impedance and

$$Z_C = \sqrt{\frac{Z_0}{Y_0}} .$$

Therefore, the positive sequence voltage $Vk1$ and the zero sequence voltage $Vk0$ at the fault point may be obtained based on the equation (15), and the positive sequence voltage drop $\Delta V1$ and the zero sequence voltage drop $\Delta V0$ at the fault point may be furthering turn obtained by using $\Delta V1 = Vm1 - Vk1$ and $\Delta V0 = Vm0 - Vk0$.

Hereinafter, calculation for the zero sequence voltage drop $\Delta V0$ to the measurement point in the zero sequence network and the positive sequence voltage drop $\Delta V1$ to the measurement point in the positive sequence network will be described in detail.

**Zero sequence voltage drop $\Delta V0$ to the measurement point**

For the zero sequence network, there is $Z_0 = zl0$ .

If we neglect a leakage conductance of the feeder, the $G_0$ may be neglected. With a assumption that a load is generally connected in the distribution network in a delta manner or an ungrounded star manner, so no load exists in the zero sequence network. Therefore the distributed shunt capacitance $C0$ will be the only admittance in the zero sequence network, and there will be $Y_0 = j\omega C0$.

Then, according to the equation (15), a following zero sequence voltage drop $\Delta V0$ may be obtained, as shown in a following equation (16).

$$\Delta V0 = Vm0 - Vk0 = Vm0 - \left( A_1^0 e^{-\gamma^0 x} + A_2^0 e^{\gamma^0 x} \right)$$

$$A_1^0 = \frac{1}{2} \left( Vm0 + Z_C^0 \cdot Im0 \right)$$

$$A_2^0 = \frac{1}{2} \left( Vm0 - Z_C^0 \cdot Im0 \right) \qquad \qquad \dots(16)$$

$$Z_C^0 = \sqrt{\frac{zl0}{j\omega C0}}$$

$$\gamma^0 = \sqrt{zl0 \cdot j\omega C0}$$

Wherein $Vm0$ and $Im0$ may be acquired by measurements and/or calculations, and $C0$ may be input by a user. Here, $C0$ is the zero sequence distributed shunt capacitance per unit length, but the embodiment of the present disclosure is not limited thereto, and other forms may also exist. Hereinafter, in order to facilitate description, $C0$ is referred to as the zero sequence distributed shunt capacitance.

It can be seen that, according to the embodiment of the present disclosure, the zero sequence voltage drop $\Delta V0$ to the measurement point may be calculated based on the zero sequence distributed shunt capacitance $C0$.

Particularly, the zero sequence feeder impedance per unit length $zl0$ and the distributed shunt capacitance $C0$ of the feeder are input by user firstly, and then the zero sequence voltage $Vm0$ and the zero sequence current $Im0$ may be obtained, that is, the zero sequence voltage drop may be obtained.

Furthermore, the impedance per unit length $Z_0$ in the zero sequence network may be calculated by using the zero sequence feeder impedance $zl0$, the admittance per unit length $Y_0$ in the zero sequence network may be calculated by using the zero sequence distributed shunt capacitance $C0$, and a first zero sequence parameter $A_1^0$ , a second zero sequence parameter $A_2^0$ , a zero sequence propagation constant $Z_C^0$ and a zero sequence characteristic impedance $\gamma^0$ may be calculated according to the zero sequence voltage $Vm0$, the zero sequence current $Im0$, the impedance per

unit length $Z_0$ in the zero sequence network, the admittance per unit length $Y_0$ in the zero sequence network; and at last the zero sequence voltage drop $\Delta V0$ may be obtained according to $A_1^0$, $A_2^0$, $Z_C^0$ and $\gamma^0$.

**Positive sequence voltage drop to the measurement point**

The influence of the load has to be considered in the positive sequence network. That is, in the positive sequence network, besides the positive sequence distributed shunt capacitance, there is also a positive sequence impedance of the load tapped on the feeder in a distributed way.

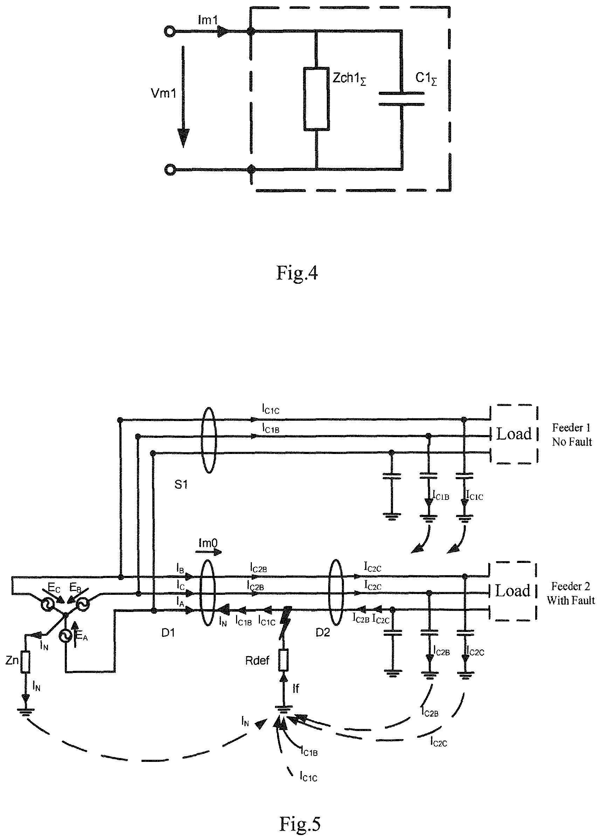

Fig.4 shows a schematic equivalent circuit of a two-terminal network representing the positive sequence network downstream from the IED, wherein the feeder impedance is neglected.

In Fig.4, a connection between the load impedance and the positive sequence capacitance is treated as a parallel connection of two lumped elements, that is: an equivalent load impedance $Zch1_\Sigma$ and an equivalent capacitance $C1_\Sigma$, wherein $C1_\Sigma = C1 \cdot l$ and $l$ is the total length of the feeder downstream from the IED.

For the equation (14), according to Fig.4, the admittance per unit length can be calculated by:

$$Y_0 = \left( \frac{1}{Zch1^{-1} + j\omega C1 \cdot l} \right) \cdot \frac{1}{l}.$$

In addition, for the positive sequence network, $Z_0 = z/1$.

In practice, the load may be treated as evenly distributed although a particular distribution of the load is unknown.

Therefore, if $Im1/Vm1$ is known, then $Y_0 = \left( \frac{Im1}{Vm1} \right) \cdot \frac{1}{l}$.

Moreover, $l$ may be estimated by using the zero sequence network.

Fig.5 shows a schematic simplified diagram for estimating $l$.

As shown in Fig.5, following relationships may be found.

$$If = I_N + I_{C1B} + I_{C1C} + I_{C2B} + I_{C2C}$$
$$Im0 = I_N + I_{C1B} + I_{C1C} + I_{C2B} + I_{C2C} - \left( I_{C2B} + I_{C2C} \right) = If - I_C$$
$$I_C = I_{C2B} + I_{C2C} = If - Im0$$

In addition, $I_C$ is a capacitive current caused by a phase-to-ground capacitance of the faulty feeder downstream from the IED, and therefore may be estimated by using a product of the zero sequence voltage $Vm0$ multiplied with a susceptance $j\omega C0$ of the zero sequence capacitance, as shown in a following equation (17).

$$I_C \approx -Vm0 \cdot j\omega C0 \cdot l \qquad\qquad ...(17)$$

So the total length $l$ of the feeder downstream from the IED may be expressed as a following equation (18).

$$l \approx real\left( \frac{If - Im0}{-Vm0 \cdot j\omega C0} \right) \qquad\qquad ...(18)$$

Then, a simplified positive sequence voltage drop $\Delta V1$ may be obtained, as shown in a following equation (19).

$$\Delta V1 = Vm1 - Vk1 = Vm1 - \left( A_1^l e^{-\gamma^l x} + A_2^l e^{\gamma^l x} \right)$$

$$A_1^l = \frac{1}{2} \left( Vm1 + Z_C^l \cdot Im1 \right)$$

$$A_2^l = \frac{1}{2} \left( Vm1 - Z_c^l \cdot Im1 \right) \qquad \ldots(19)$$

$$Z_C^l = \sqrt{zl1 \cdot \frac{Vm1 \cdot l}{Im1}}$$

$$\gamma^l = \sqrt{zl1 \cdot \frac{Im1}{Vm1 \cdot l}}$$

Therefore, according to the embodiment of the present disclosure, the positive sequence voltage drop $\Delta V1$ to the measurement point may be calculated only based on the zero sequence distributed shunt capacitance $C0$ without the positive sequence distributed shunt capacitance $C1$. Herein, $C1$ is the positive sequence distributed shunt capacitance per unit length, but the embodiment of the present disclosure is not limited thereto, and other forms may also exist. Hereinafter, in order to facilitate description, $C1$ is referred to as the positive sequence distributed shunt capacitance.

Particularly, the positive sequence feeder impedance per unit length $zl1$ and the zero sequence distributed shunt capacitance $C0$ of the feeder are input by user firstly, and then the positive sequence voltage $Vm1$, the positive sequence current $Im1$ and the earth fault current $3 \cdot If$ may be obtained, that is, the positive sequence voltage drop may be obtained.

Furthermore, the impedance per unit length $Z_0$ in the positive sequence network may be calculated by using the positive sequence feeder impedance $zl1$; the total length of the feeder downstream from the IED may be calculated by using the earth fault current $3 \cdot If$, the zero sequence voltage $Vm0$, the zero sequence current $Im0$ and the zero sequence distributed shunt capacitance $C0$; and the admittance per unit length $Y_0$ in the positive sequence network may be calculated by using the total length of the feeder downstream from the IED, the positive sequence voltage $Vm1$ and the positive sequence current $Im1$; and a first positive sequence parameter $A_1^l$, a second positive sequence parameter $A_2^l$, a positive sequence propagation constant $Z_C^l$ and a positive sequence characteristic impedance $\gamma^l$ may be calculated according to the positive sequence voltage $Vm1$, the positive sequence current $Im1$, the impedance per unit length $Z_0$ in the positive sequence network and the admittance per unit length $Y_0$ in the positive sequence network; and at last the positive sequence voltage drop $\Delta V1$ may be obtained according to $A_1^l$, $A_2^l$, $Z_C^l$ and $\gamma^l$.

### Calculation of the distance to the measurement point from the fault point

Based on the fact that the fault impedance $Rdef$ only has a real part, x may be calculated by substituting the equations (16) and (17) into the equation (8). That is, since an imaginary part of the fault impedance $Rdef$ is zero, x may be calculated by a following equation (20).

$$imag\left(\frac{Vm}{If}\right) - imag\left(\frac{\Delta V1 + zl2 \cdot x \cdot Im2 + \Delta V0}{If}\right) = 0 \qquad \ldots(20)$$

In addition, the real part of $Rdef$ may be expressed as a following equation (21).

$$Rdef = real\left(\frac{Vm - (\Delta V1 + zl2 \cdot x \cdot Im2 + \Delta V0)}{3 \cdot If}\right) \qquad \ldots(21)$$

Therefore, according to the embodiment of the present disclosure, the zero sequence component (the zero sequence voltage drop) and the positive sequence component (the positive sequence voltage drop) are calculated by taking the distributed shunt capacitance of the feeder into consideration, so that the accuracy of the determined fault location may be ensured even in the case that the percentage of the underground cable is high. As such, the accuracy of the determined fault location may be ensured only by means of inputting $C0$ by the users additionally.

Following tables 2 and 3 show results of determining the location of the earth fault according to the embodiment of the present disclosure, respectively, wherein data in the table 2 is obtained for a case of effective neutral grounding and the table 3 is obtained for a case of compensative neutral grounding.

Table 2

| Real Distance /km | Original Method/km | Proposed Solution /km | Neutral Grounding | Cable Percent |
|---|---|---|---|---|
| 1 | 0.97 | 0.99 | effective | 10% |
| 5 | 4.99 | 4.91 | effective | 10% |
| 10 | 10.25 | 9.87 | effective | 10% |
| 1 | 0.97 | 0.98 | effective | 60% |
| 5 | 4.54 | 4.96 | effective | 60% |
| 10 | 9.65 | 9.96 | effective | 60% |
| 1 | 0.64 | 0.96 | effective | 80% |
| 5 | 3.94 | 4.92 | effective | 80% |
| 10 | 9.56 | 9.90 | effective | 80% |
| 1 | 0.44 | 0.94 | effective | 100% |
| 5 | 1.05 | 4.75 | effective | 100% |
| 10 | 6.60 | 9.85 | effective | 100% |

Table 3

| Real Distance /km | Original Method/km | Proposed Solution /km | Neutral Grounding | Cable Percent |
|---|---|---|---|---|
| 1 | 0.93 | 0.98 | compensative | 10% |
| 5 | 4.90 | 4.91 | compensative | 10% |
| 10 | 10.19 | 19.91 | compensative | 10% |
| 1 | 0.42 | 0.96 | compensative | 60% |
| 5 | 2.77 | 4.92 | compensative | 60% |
| 10 | 7.20 | 9.93 | compensative | 60% |
| 1 | -1.53 | 1.05 | compensative | 100% |
| 5 | -5.18 | 5.54 | compensative | 100% |
| 10 | -3.47 | 9.82 | compensative | 100% |

It can be seen from the tables 2 and 3, the embodiment of the present disclosure may obtain an accurate localization result no matter what the percentage of the underground cable is.

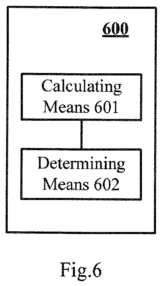

Fig.6 shows a schematic block diagram of a device 600 for determining a location of an earth fault according to the embodiments of the present disclosure. The device 600 may be a protection relay, a fault passage indicator (FPI), a remote terminal unit (RTU), etc., or a member in the protection relay, the fault passage indicator (FPI) and the remote terminal unit (RTU), or may a separate device cooperating with the protection relay, the fault passage indicator (FPI) and the remote terminal unit (RTU).

As shown in Fig.6, the device 600 includes a calculating means 601 and a determining means 602.

The calculating means 601 is used for calculating a zero sequence component and a positive sequence component in a grid based on a distributed shunt capacitance. The determining means 602 is used for determining a distance to a measuring point from an earth fault point by using a negative sequence component, the calculated zero sequence component and the calculated positive sequence component.

Therefore, according to the embodiment of the present disclosure, the calculating means 601 calculates the zero sequence component and the positive sequence component by taking the distributed shunt capacitance into consideration, so that the accuracy of the fault location determined by the determining means 602 may be ensured even in the case that the percentage of the underground cable is high.

Particularly, the calculating means 601 may perform process for calculating the zero sequence voltage drop $\Delta V0$ and the positive sequence voltage drop $\Delta V1$ by using the equation (16) and the equation (17), respectively. For example, for the zero sequence voltage drop $\Delta V0$, the calculating means 601 may firstly receives the zero sequence feeder impedance per unit length $zl0$ and the distributed shunt capacitance $C0$ input by user, and then obtains the zero sequence voltage $Vm0$ and the zero sequence current $Im0$, that is, obtains the zero sequence voltage drop.

Furthermore, the calculating means 601 may calculate the impedance per unit length $Z_0$ in the zero sequence network by using the zero sequence feeder impedance $zl0$, may calculate the admittance per unit length $Y_0$ in the zero sequence network by using the zero sequence distributed shunt capacitance $C0$, and may calculate a first zero sequence parameter $A_1^0$, a second zero sequence parameter $A_2^0$, a zero sequence propagation constant $Z_C^0$ and a zero sequence characteristic impedance $\gamma^0$ according to the zero sequence voltage $Vm0$, the zero sequence current $ImO$, the impedance per unit length $Z_0$ in the zero sequence network, the admittance per unit length $Y_0$ in the zero sequence network; and at last may obtain the zero sequence voltage drop $\Delta VO$ according to $A_1^0$, $A_2^0$, $Z_C^0$ and $\gamma^0$.

In addition, for the positive sequence voltage drop $\Delta V1$, the calculating means 601 may firstly receive the positive sequence feeder impedance per unit length $zl1$ and the zero sequence distributed shunt capacitance $C0$ input by user, and then may obtain the positive sequence voltage $Vm1$, the positive sequence current $Im1$ and the earth fault current $3 \cdot If$, that is, may obtain the positive sequence voltage drop $\Delta V1$.

Furthermore, the calculating means 601 may calculate the impedance per unit length $Z_0$ in the positive sequence network by using the positive sequence feeder impedance $zl1$; may calculate the total length of the feeder downstream from the IED by using the earth fault current $3 \cdot If$, the zero sequence voltage $Vm0$, the zero sequence current $Im0$ and the zero sequence distributed shunt capacitance $C0$; may calculate the admittance per unit length $Y_0$ in the positive sequence network by using the total length $l$ of the feeder downstream from the IED, the positive sequence voltage $Vm1$ and the positive sequence current $Im1$; and may calculate a first positive sequence parameter $A_1^1$, a second positive sequence parameter $A_2^1$, a positive sequence propagation constant $Z_C^1$ and a positive sequence characteristic impedance $\gamma^1$ according to the positive sequence voltage $Ym1$, the positive sequence current $Im1$, the impedance per unit length $Z_0$ in the positive sequence network and the admittance per unit length $Y_0$ in the positive sequence network; and at last may obtain the positive sequence voltage drop $\Delta V1$ according to $A_1^1$, $A_2^1$, $Z_C^1$ and $\gamma^1$.

Thereafter, based on the fact that the imaginary part of the phase-to-earth fault impedance $Rdef$ is zero at the fault point, the determining means 602 may determine the distance x to the measurement point from the earth fault point by using the equation (20).

It should be noted that individual drawings only show parts related to the embodiments of the present disclosure for the sake of conciseness and clarity, but those skilled in the art should understand that the device and apparatus shown in the drawings may include other necessary units.

Those skilled in the art should realize that various units or parts described with reference to the embodiments of the present disclosure may be implemented in a form of electronic hardware, computer software or combination thererof, and components or steps of the embodiments of the present disclosure have been described generally in term of functions so as to clearly illustrate interchangeability between a hardware implementation and a software implementation. Whether one of functions is implemented in the form of hardware or in the form of software is dependent on a particular application to which the technical solution is applied and particular design constraints. For each specific application, different methods may be used by professionals to achieve the described functionality, but such implementation should not be construed as exceeding the scope of the present disclosure.

It should be understood from the embodiments provided in the present disclosure that the disclosed systems and apparatus can be implemented in other ways. For example, the above-described device embodiments are merely illustrative in nature, such as the division of the units, just is a logic function division, and another division manner may be adopted in an actual implementation, for example a plurality of units or components may be combined or can be integrated into another system, or some of the features can be ignored or not performed. In addition, mutual coupling or direct coupling or communication connection discussed above may be an indirectly coupling or a communication connection via a number of interfaces, devices or units, an may be electrical, mechanical, or other form.

Units described as separate members may be or may not be physically separated, and components shown as a cell may be or may not be physical units, either can be located in a place, or can be distributed to a plurality of network units. According to the actual requirements, part or all of the units can be selected to achieve the purpose of the technical solution of the present disclosure.

Furthermore, the individual functional units in various embodiments of the present disclosure may be integrated into one processing unit, or each unit may be a separate physical presence, or two or more units may be integrated into a single unit. The integrated units can be implemented both in the form of hardware and in the form of software function units.

Said integrated unit can be stored in a computer readable storage medium when it is implemented in the form of software function units and is sold or used as an independent product. Based on this understanding, the technical solution of the present disclosure in essence or the part of the technical solution contributing to the prior art of the technical solution, or all or part of the technical solution may be embodied in the form of software products, the computer software product is stored in a storage medium and includes instructions for making a computer device (may be a personal computer, a server, or network equipment) to perform all or part of steps of the method as provided in the various embodiments of the present invention. The storage medium may include: U disk, mobile hard disk, Read-Only Memory (ROM,), a Random Access Memory (RAM,), magnetic disk, or CD-ROM, and other media capable of storing program codes

It should also be noted that, in the device of the present invention, it is obvious that the various components can be decomposed and/or recombined.

Above are only specific embodiments of the present disclosure, and the scope of the present disclosure is not so limited. Any ordinary person skilled in the art may easily make various modifications and alterations, and it is intended that all these modifications and alterations should be encompassed within the appended claims. Therefore, the scope of the present disclosure should be defined by the appended claims.

**Claims**

1. A method for determining a location of an earth fault (100), **characterized by** comprising:

   calculating a zero sequence component and a positive sequence component in a grid based on a distributed shunt capacitance (101); and
   determining a distance to a measuring point from an earth fault point based on a negative sequence component, the calculated zero sequence component and the calculated positive sequence component (102).

2. The method (100) of claim 1, wherein the calculating a zero sequence component and a positive sequence component in a grid based on a distributed shunt capacitance (101) further comprises:

   calculating a zero sequence voltage drop to the measurement point based on a zero sequence distributed shunt capacitance; and
   calculating a positive sequence voltage drop to the measurement point based on the zero sequence distributed shunt capacitance.

3. The method (100) of claim 2, wherein the calculating a zero sequence voltage drop to the measurement point based on a zero sequence distributed shunt capacitance further comprises:

   receiving an input zero sequence feeder impedance per unit length and an input zero sequence distributed shunt capacitance;
   obtaining a zero sequence voltage and a zero sequence current; and
   calculating the zero sequence voltage drop.

4. The method (100) of claim 3, wherein the calculating the zero sequence voltage drop further comprises:

   calculating an impedance per unit length in a zero sequence network by using the zero sequence feeder impedance;
   calculating an admittance per unit length in the zero sequence network by using the zero sequence distributed shunt capacitance; and

calculating a first zero sequence parameter, a second zero sequence parameter, a zero sequence propagation constant and a zero sequence characteristic impedance according to the zero sequence voltage, the zero sequence current, the impedance per unit length in the zero sequence network, and the admittance per unit length in the zero sequence network; and
obtaining the zero sequence voltage drop according to the first zero sequence parameter, the second zero sequence parameter, the zero sequence propagation constant and the zero sequence characteristic impedance.

5. The method (100) of claim 4, wherein the calculating a positive sequence voltage drop to the measurement point based on the zero sequence distributed shunt capacitance further comprises:

receiving an input positive sequence feeder impedance per unit length;
obtaining a positive sequence voltage and a positive sequence current;
obtaining an earth fault current; and
calculating the positive sequence voltage drop.

6. The method (100) of claim 5, wherein the calculating the positive sequence voltage drop further comprises:

calculating an impedance per unit length in the positive sequence network by using the positive sequence feeder impedance;
calculating a total length of a downstream feeder by using the earth fault current, the zero sequence voltage, the zero sequence current and the zero sequence distributed shunt capacitance;
calculating an admittance per unit length in the positive sequence network by using the total length of the downstream feeder , the positive sequence voltage and the positive sequence current;
calculating a first positive sequence parameter, a second positive sequence parameter, a positive sequence propagation constant and a positive sequence characteristic impedance according to the positive sequence voltage, the positive sequence current, the impedance per unit length in the positive sequence network and the admittance per unit length in the positive sequence network; and
obtaining the positive sequence voltage drop according to the first positive sequence parameter, the second positive sequence parameter, the positive sequence propagation constant and the positive sequence characteristic impedance.

7. The method (100) of claim 6, wherein the determining a distance to a measuring point from an earth fault point by using a negative sequence component, the calculated zero sequence component and the calculated positive sequence component (102) further comprises:
determining the distance to the measurement point from the earth fault point based on the fact that an imaginary part of a phase-to-earth fault impedance at the earth fault point is zero.

8. A device (600) for determining a location of an earth fault, **characterized by** comprising:

a calculating means (601) for calculating a zero sequence component and a positive sequence component in a grid based on a distributed shunt capacitance; and
a determining means (602) for determining a distance to a measuring point from an earth fault point based on a negative sequence component, the calculated zero sequence component and the calculated positive sequence component.

9. The device of claim 8, wherein the calculating means (601) is configured to:

calculate a zero sequence voltage drop to the measurement point based on a zero sequence distributed shunt capacitance; and
calculate a positive sequence voltage drop to the measurement point based on the zero sequence distributed shunt capacitance.

10. The device of claim 9, wherein the calculating means (601) calculates a zero sequence voltage drop to the measurement point based on a zero sequence distributed shunt capacitance further comprises:

the calculating means (601) receives an input zero sequence feeder impedance per unit length and an input zero sequence distributed shunt capacitance;
the calculating means (601) obtains a zero sequence voltage and a zero sequence current; and

the calculating means (601) calculates the zero sequence voltage drop.

11. The device of claim 10, wherein the calculating means (601) calculates the zero sequence voltage drop further comprises:

the calculating means (601) calculates an impedance per unit length in the zero sequence network by using the zero sequence feeder impedance;
the calculating means (601) calculates an admittance per unit length in the zero sequence network by using the zero sequence distributed shunt capacitance; and
the calculating means (601) calculates a first zero sequence parameter, a second zero sequence parameter, a zero sequence propagation constant and a zero sequence characteristic impedance according to the zero sequence voltage, the zero sequence current, the impedance per unit length in the zero sequence network and the admittance per unit length in the zero sequence network; and
the calculating means (601) obtains the zero sequence voltage drop according to the first zero sequence parameter, the second zero sequence parameter, the zero sequence propagation constant and the zero sequence characteristic impedance.

12. The device of claim 11, wherein the calculating means (601) calculates a positive sequence voltage drop to the measurement point based on the zero sequence distributed shunt capacitance further comprises:

the calculating means (601) receives an input positive sequence feeder impedance per unit length;
the calculating means (601) obtains a positive sequence voltage and a positive sequence current;
the calculating means (601) obtains an earth fault current; and
the calculating means (601) calculates the positive sequence voltage drop.

13. The device of claim 12, wherein the calculating means (601) calculates the positive sequence voltage drop further comprises:

the calculating means (601) calculates an impedanee per unit length in the positive sequence network by using the positive sequence feeder impedance;
the calculating means (601) calculates a total length of a downstream feeder by using the earth fault current, the zero sequence voltage, the zero sequence current and the zero sequence distributed shunt capacitance;
the calculating means (601) calculates an admittance per unit length in the positive sequence network by using the total length of the downstream feeder, the positive sequence voltage and the positive sequence current;
the calculating means (601) calculates a first positive sequence parameter, a second positive sequence parameter, a positive sequence propagation constant and a positive sequence characteristic impedance according to the positive sequence voltage, the positive sequence current, the impedance per unit length in the positive sequence network and the admittance per unit length in the positive sequence network; and
the calculating means (601) obtains the positive sequence voltage drop according to the first positive sequence parameter, the second positive sequence parameter, the positive sequence propagation constant and the positive sequence characteristic impedance.

14. The device of claim 13, wherein the determining means (602) determines the distance to the measurement point from the earth fault point based on the fact that an imaginary part of an phase-to-earth fault impedance at the earth fault point is zero.

**Patentansprüche**

1. Verfahren (100) zur Bestimmung des Ortes eines Erdschlusses, **dadurch gekennzeichnet, dass** es umfasst:

Berechnen (101) einer Nullsystem-Komponente und einer Mitsystem-Komponente in einem Stromnetz auf der Grundlage einer verteilten Nebenschluss-Kapazität; und
Bestimmen (102) eines Abstands zu einem Messpunkt von einem Erdschlusspunkt auf der Grundlage einer Gegensystem-Komponente, der berechneten Nullsystem-Komponente und der berechneten Mitsystem-Komponente.

2. Verfahren (100) nach Anspruch 1, wobei das Berechnen (101) einer Nullsystem-Komponente und einer Mitsystem-Komponente in einem Stromnetz auf der Grundlage einer verteilten Nebenschluss-Kapazität ferner umfasst:

> Berechnen eines Nullsystem-Spannungsabfalls zu dem Messpunkt auf der Grundlage einer verteilten Nullsystem-Nebenschluss-Kapazität; und
> Berechnen eines Mitsystem-Spannungsabfalls zu dem Messpunkt auf der Grundlage der verteilten Nullsystem-Nebenschluss-Kapazität.

3. Verfahren (100) nach Anspruch 2, wobei das Berechnen eines Nullsystem-Spannungsabfalls zu dem Messpunkt auf der Grundlage einer verteilten Nullsystem-Nebenschluss-Kapazität ferner umfasst:

> Empfangen einer Eingangs-Nullsystem-Einspeiseimpedanz pro Längeneinheit und einer verteilten Eingangs-Nullsystem-Nebenschluss-Kapazität;
> Ermitteln einer Nullsystem-Spannung und eines Nullsystem-Stroms; und
> Berechnen des Nullsystem-Spannungsabfalls.

4. Verfahren (100) nach Anspruch 3, wobei das Berechnen des Nullsystem-Spannungsabfalls weiterhin umfasst:

> Berechnen einer Impedanz pro Längeneinheit in einem Nullsystem-Netzwerk unter Verwendung der Nullsystem-Einspeiseimpedanz;
> Berechnen einer Admittanz pro Längeneinheit in dem Nullsystem-Netzwerk unter Verwendung der verteilten Nullsystem-Nebenschluss-Kapazität; und
> Berechnen eines ersten Nullsystem-Parameters, eines zweiten Nullsystem-Parameters, einer Nullsystem-Ausbreitungskonstante und einer charakteristischen Nullsystem-Impedanz gemäß der Nullsystem-Spannung, dem Nullsystem-Strom, der Impedanz pro Längeneinheit in dem Nullsystem-Netzwerk und der Admittanz pro Längeneinheit in dem Nullsystem-Netzwerk; und
> Ermitteln des Nullsystem-Spannungsabfalls entsprechend dem ersten Nullsystem-Parameter, dem zweiten Nullsystem-Parameter, der Nullsystem-Ausbreitungskonstante und der charakteristischen Nullsystem-Impedanz.

5. Verfahren (100) nach Anspruch 4, wobei das Berechnen eines Mitsystem-Spannungsabfalls zu dem Messpunkt auf der Grundlage der verteilten Nullsystem-Nebenschluss-Kapazität weiterhin umfasst:

> Empfangen einer Eingangs-Mitsystem-Einspeiseimpedanz pro Längeneinheit;
> Ermitteln einer Mitsystem-Spannung und eines Mitsystem-Stroms;
> Ermitteln eines Erdschlussstroms; und
> Berechnen des Mitsystem-Spannungsabfalls.

6. Verfahren (100) nach Anspruch 5, wobei das Berechnen des Mitsystem-Spannungsabfalls weiterhin umfasst:

> Berechnen einer Impedanz pro Längeneinheit in dem Mitsystem-Netzwerk unter Verwendung der Mitsystem-Einspeiseimpedanz;
> Berechnen einer Gesamtlänge einer nachgeschalteten Einspeisung unter Verwendung des Erdschlussstroms, der Nullsystem-Spannung, des Nullsystem-Stroms und der verteilten Nullsystem-Nebenschluss-Kapazität;
> Berechnen einer Admittanz pro Längeneinheit in dem Mitsystem-Netzwerk unter Verwendung der Gesamtlänge der nachgeschalteten Einspeisung, der Mitsystem-Spannung und des Mitsystem-Stroms;
> Berechnen eines ersten Mitsystem-Parameters, eines zweiten Mitsystem-Parameters, einer Mitsystem-Ausbreitungskonstante und einer charakteristischen Mitsystem-Impedanz entsprechend der Mitsystem-Spannung, dem Mitsystem-Strom, der Impedanz pro Längeneinheit in dem Mitsystem-Netzwerk und der Admittanz pro Längeneinheit in dem Mitsystem-Netzwerk; und
> Ermitteln des Mitsystem-Spannungsabfalls entsprechend dem ersten Mitsystem-Parameter, dem zweiten Mitsystem-Parameter, der Mitsystem-Ausbreitungskonstante und der charakteristischen Mitsystem-Impedanz.

7. Verfahren (100) nach Anspruch 6, wobei das Bestimmen (102) eines Abstands zu einem Messpunkt von einem Erdschlusspunkt unter Verwendung einer Gegensystem-Komponente, der berechneten Nullsystem-Komponente und der berechneten Mitsystem-Komponente ferner umfasst:
Bestimmen des Abstands zu dem Messpunkt von dem Erdschlusspunkt auf der Grundlage der Tatsache, dass ein Imaginärteil einer Phase-Erdschluss-Impedanz am Erdschlusspunkt Null ist.

**8.** Vorrichtung (600) zur Bestimmung des Ortes eines Erdschlusses, **dadurch gekennzeichnet, dass** sie umfasst:

ein Berechnungsmittel (601) zum Berechnen einer Nullsystem-Komponente und einer Mitsystem-Komponente in einem Stromnetz auf der Grundlage einer verteilten Nebenschluss-Kapazität; und
ein Bestimmungsmittel (602) zum Bestimmen eines Abstands zu einem Messpunkt von einem Erdschlusspunkt auf der Grundlage einer Gegensystem-Komponente, der berechneten Nullsystem-Komponente und der berechneten Mitsystem-Komponente.

**9.** Vorrichtung nach Anspruch 8, wobei das Berechnungsmittel (601) konfiguriert ist, um:

einen Nullsystem-Spannungsabfall zu dem Messpunkt auf der Grundlage einer verteilten Nullsystem-Nebenschluss-Kapazität zu berechnen; und
einen Mitsystem-Spannungsabfall zu dem Messpunkt auf der Grundlage der verteilten Nullsystem-Nebenschluss-Kapazität zu berechnen.

**10.** Vorrichtung nach Anspruch 9, wobei das Merkmal, dass das Berechnungsmittel (601) einen Nullsystem-Spannungsabfall zu dem Messpunkt auf der Grundlage einer verteilten Nullsystem-Nebenschluss-Kapazität berechnet, ferner umfasst, dass:

das Berechnungsmittel (601) eine Eingangs-Nullsystem-Einspeiseimpedanz pro Längeneinheit und eine verteilte Eingangs-Nullsystem-Nebenschluss-Kapazität empfängt;
das Berechnungsmittel (601) eine Nullsystem-Spannung und einen Nullsystem-Strom ermittelt; und
das Berechnungsmittel (601) den Nullsystem-Spannungsabfall berechnet.

**11.** Vorrichtung nach Anspruch 10, wobei das Merkmal, dass das Berechnungsmittel (601) den Nullsystem-Spannungsabfall berechnet, ferner umfasst, dass:

das Berechnungsmittel (601) eine Impedanz pro Längeneinheit in dem Nullsystem-Netzwerk berechnet, indem es die Nullsystem-Einspeisungs-Impedanz verwendet;
das Berechnungsmittel (601) eine Admittanz pro Längeneinheit in dem Nullsystem-Netzwerk unter Verwendung der verteilten Nullsystem-Nebenschluss-Kapazität berechnet; und
das Berechnungsmittel (601) einen ersten Nullsystem-Parameter, einen zweiten Nullsystem-Parameter, eine Nullsystem-Ausbreitungskonstante und eine charakteristische Nullsystem-Impedanz gemäß der Nullsystem-Spannung, dem Nullsystem-Strom, der Impedanz pro Längeneinheit in dem Nullsystem-Netzwerk und der Admittanz pro Längeneinheit in dem Nullsystem-Netzwerk berechnet; und
das Berechnungsmittel (601) den Nullsystem-Spannungsabfall entsprechend dem ersten Nullsystem-Parameter, dem zweiten Nullsystem-Parameter, der Nullsystem-Ausbreitungskonstante und der charakteristischen Nullsystem-Impedanz ermittelt.

**12.** Vorrichtung nach Anspruch 11, wobei das Merkmal, dass das Berechnungsmittel (601) einen Mitsystem-Spannungsabfall zu dem Messpunkt auf der Grundlage der verteilten Nullsystem-Nebenschluss-Kapazität berechnet, ferner umfasst, dass:

das Berechnungsmittel (601) eine Eingangs-Mitsystem-Einspeiseimpedanz pro Längeneinheit empfängt;
das Berechnungsmittel (601) eine Mitsystem-Spannung und einen Mitsystem-Strom ermittelt;
das Berechnungsmittel (601) einen Erdschlussstrom ermittelt; und
das Berechnungsmittel (601) den Mitsystem-Spannungsabfall berechnet.

**13.** Vorrichtung nach Anspruch 12, wobei das Merkmal, dass das Berechnungsmittel (601) den Mitsystem-Spannungsabfall berechnet, ferner umfasst, dass:

das Berechnungsmittel (601) eine Impedanz pro Längeneinheit in dem Mitsystem-Netzwerk berechnet, indem es die Mitsystem-Einspeiseimpedanz verwendet;
das Berechnungsmittel (601) eine Gesamtlänge einer nachgeschalteten Einspeisung unter Verwendung des Erdschlussstroms, der Nullsystem-Spannung, des Nullsystem-Stroms und der verteilten Nullsystem-Nebenschluss-Kapazität berechnet;
das Berechnungsmittel (601) eine Admittanz pro Längeneinheit in dem Mitsystem-Netzwerk berechnet, indem es die Gesamtlänge der nachgeschalteten Einspeisung, die Mitsystem-Spannung und den Mitsystem-Strom verwendet;

das Berechnungsmittel (601) einen ersten Mitsystem-Parameter, einen zweiten Mitsystem-Parameter, eine Mitsystem-Ausbreitungskonstante und eine charakteristische Mitsystem-Impedanz gemäß der Mitsystem-Spannung, dem Mitsystem-Strom, der Impedanz pro Längeneinheit in dem Mitsystem-Netzwerk und der Admittanz pro Längeneinheit in dem Mitsystem-Netzwerk berechnet; und

das Berechnungsmittel (601) den Mitsystem-Spannungsabfall gemäß dem ersten Mitsystem-Parameter, dem zweiten Mitsystem-Parameter, der Mitsystem-Ausbreitungskonstante und der charakteristischen Mitsystem-Impedanz ermittelt.

**14.** Vorrichtung nach Anspruch 13, wobei das Bestimmungsmittel (602) den Abstand zu dem Messpunkt von dem Erdschlusspunkt auf der Grundlage der Tatsache bestimmt, dass ein Imaginärteil einer Phase-Erdschluss-Impedanz am Erdschlusspunkt Null ist.

**Revendications**

**1.** Procédé pour déterminer un emplacement d'un défaut à la terre (100), **caractérisé en ce qu'**il comprend les étapes consistant à :

calculer une composante homopolaire et une composante directe dans un réseau sur la base d'une capacité shunt distribuée (101) ; et

déterminer une distance à un point de mesure depuis un point de défaut à la terre sur la base d'une composante inverse, de la composante homopolaire calculée et de la composante directe calculée (102).

**2.** Procédé (100) selon la revendication 1, dans lequel l'étape consistant à calculer une composante homopolaire et une composante directe dans un réseau sur la base d'une capacité shunt distribuée (101) comprend en outre les étapes consistant à :

calculer une chute de tension homopolaire au point de mesure sur la base d'une capacité shunt distribuée homopolaire ; et

calculer une chute de tension directe au point de mesure sur la base de la capacité shunt distribuée homopolaire.

**3.** Procédé (100) selon la revendication 2, dans lequel l'étape consistant à calculer une chute de tension homopolaire au point de mesure sur la base d'une capacité shunt distribuée homopolaire comprend en outre les étapes consistant à :

recevoir une impédance de feeder homopolaire d'entrée par unité de longueur et une capacité shunt distribuée homopolaire d'entrée ;

obtenir une tension homopolaire et un courant homopolaire ; et

calculer la chute de tension homopolaire.

**4.** Procédé (100) selon la revendication 3, dans lequel l'étape consistant à calculer la chute de tension homopolaire comprend en outre les étapes consistant à :

calculer une impédance par unité de longueur dans un réseau homopolaire en utilisant l'impédance de feeder homopolaire ;

calculer une admittance par unité de longueur dans le réseau homopolaire en utilisant la capacité shunt distribuée homopolaire ; et

calculer un premier paramètre homopolaire, un second paramètre homopolaire, une constante de propagation homopolaire et une impédance caractéristique homopolaire en fonction de la tension homopolaire, du courant homopolaire, de l'impédance par unité de longueur dans le réseau homopolaire et de l'admittance par unité de longueur dans le réseau homopolaire ; et

obtenir la chute de tension homopolaire en fonction du premier paramètre homopolaire, du second paramètre homopolaire, de la constante de propagation homopolaire et de l'impédance caractéristique homopolaire.

**5.** Procédé (100) selon la revendication 4, dans lequel l'étape consistant à calculer une chute de tension directe au point de mesure sur la base de la capacité shunt distribuée homopolaire comprend en outre les étapes consistant à :

recevoir une impédance de feeder directe d'entrée par unité de longueur ;
obtenir une tension directe et un courant direct ;
obtenir un courant de défaut à la terre ; et
calculer la chute de tension directe.

**6.** Procédé (100) selon la revendication 5, dans lequel l'étape consistant à calculer la chute de tension directe comprend en outre les étapes consistant à :

calculer une impédance par unité de longueur dans le réseau direct en utilisant l'impédance de feeder directe ;
calculer une longueur totale d'un feeder aval en utilisant le courant de défaut à la terre, la tension homopolaire, le courant homopolaire et la capacité shunt distribuée homopolaire ;
calculer une admittance par unité de longueur dans le réseau direct en utilisant la longueur totale du feeder aval, la tension directe et le courant direct ;
calculer un premier paramètre direct, un second paramètre direct, une constante de propagation directe et une impédance caractéristique directe en fonction de la tension directe, du courant direct, de l'impédance par unité de longueur dans le réseau direct et de l'admittance par unité de longueur dans le réseau direct ; et
obtenir la chute de tension directe en fonction du premier paramètre direct, du second paramètre direct, de la constante de propagation directe et de l'impédance caractéristique directe.

**7.** Procédé (100) selon la revendication 6, dans lequel l'étape consistant à déterminer une distance à un point de mesure depuis un point de défaut à la terre en utilisant une composante inverse, la composante homopolaire calculée et la composante directe calculée (102) comprend en outre l'étape consistant à :
déterminer la distance au point de mesure depuis le point de défaut à la terre sur la base du fait qu'une partie imaginaire d'une impédance de défaut phase-terre au point de défaut à la terre est nulle.

**8.** Dispositif (600) pour déterminer un emplacement d'un défaut à la terre, **caractérisé en ce qu'**il comprend :

un moyen de calcul (601) pour calculer une composante homopolaire et une composante directe dans un réseau sur la base d'une capacité shunt distribuée ; et
un moyen de détermination (602) pour déterminer une distance à un point de mesure depuis un point de défaut à la terre sur la base d'une composante inverse, de la composante homopolaire calculée et de la composante directe calculée.

**9.** Dispositif selon la revendication 8, dans lequel le moyen de calcul (601) est configuré pour :

calculer une chute de tension homopolaire au point de mesure sur la base d'une capacité shunt distribuée homopolaire ; et
calculer une chute de tension directe au point de mesure sur la base de la capacité shunt distribuée homopolaire.

**10.** Dispositif selon la revendication 9, dans lequel le fait que le moyen de calcul (601) calcule une chute de tension homopolaire au point de mesure sur la base d'une capacité shunt distribuée homopolaire consiste en outre en ce que :

le moyen de calcul (601) reçoit une impédance de feeder homopolaire d'entrée par unité de longueur et une capacité shunt distribuée homopolaire d'entrée ;
le moyen de calcul (601) obtient une tension homopolaire et un courant homopolaire ; et
le moyen de calcul (601) calcule la chute de tension homopolaire.

**11.** Dispositif selon la revendication 10, dans lequel le fait que le moyen de calcul (601) calcule la chute de tension homopolaire consiste en outre en ce que :

le moyen de calcul (601) calcule une impédance par unité de longueur dans le réseau homopolaire en utilisant l'impédance de feeder homopolaire ;
le moyen de calcul (601) calcule une admittance par unité de longueur dans le réseau homopolaire en utilisant la capacité shunt distribuée homopolaire ; et
le moyen de calcul (601) calcule un premier paramètre homopolaire, un second paramètre homopolaire, une constante de propagation homopolaire et une impédance caractéristique homopolaire en fonction de la tension homopolaire, du courant homopolaire, de l'impédance par unité de longueur dans le réseau homopolaire et de l'admittance par unité de longueur dans le réseau homopolaire ; et

le moyen de calcul (601) obtient la chute de tension homopolaire en fonction du premier paramètre homopolaire, du second paramètre homopolaire, de la constante de propagation homopolaire et de l'impédance caractéristique homopolaire.

12. Dispositif selon la revendication 11, dans lequel le fait que le moyen de calcul (601) calcule une chute de tension directe au point de mesure sur la base de la capacité shunt distribuée homopolaire consiste en outre en ce que :

le moyen de calcul (601) reçoit une impédance de feeder directe d'entrée par unité de longueur ;
le moyen de calcul (601) obtient une tension directe et un courant direct ;
le moyen de calcul (601) obtient un courant de défaut à la terre ; et
le moyen de calcul (601) calcule la chute de tension directe.

13. Dispositif selon la revendication 12, dans lequel le fait que le moyen de calcul (601) calcule la chute de tension directe consiste en outre en ce que :

le moyen de calcul (601) calcule une impédance par unité de longueur dans le réseau direct en utilisant l'impédance de feeder directe ;
le moyen de calcul (601) calcule une longueur totale d'un feeder aval en utilisant le courant de défaut à la terre, la tension homopolaire, le courant homopolaire et la capacité shunt distribuée homopolaire ;
le moyen de calcul (601) calcule une admittance par unité de longueur dans le réseau direct en utilisant la longueur totale du feeder aval, la tension directe et le courant direct ;
le moyen de calcul (601) calcule un premier paramètre direct, un second paramètre direct, une constante de propagation directe et une impédance caractéristique directe en fonction de la tension directe, du courant direct, de l'impédance par unité de longueur dans le réseau direct et de l'admittance par unité de longueur dans le réseau direct ; et
le moyen de calcul (601) obtient la chute de tension directe en fonction du premier paramètre direct, du second paramètre direct, de la constante de propagation directe et de l'impédance caractéristique directe.

14. Dispositif selon la revendication 13, dans lequel le moyen de détermination (602) détermine la distance au point de mesure depuis le point de défaut à la terre sur la base du fait qu'une partie imaginaire d'une impédance de défaut phase-terre au point de défaut à la terre est nulle.

**100**

Fig.1

Fig.2

Fig.3

Fig.4

Fig.5

Fig.6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060142964 A1